# EUROPÄISCHE PATENTANMELDUNG

(11) **EP 4 442 893 A1**
(43) Veröffentlichungstag der Anmeldung: **09.10.2024**
(21) Anmeldenummer: 24163611.7
(22) Anmeldetag: 14.03.2024
(51) Int. Cl.: D06F 34/32, F21Y 105/00, F21Y 115/15

(54) **WÄSCHEPFLEGEGERÄT MIT EINEM BELEUCHTUNGSELEMENT**

(30) Priorität: 03.04.2023 DE 102023203059
(71) Anmelder: BSH Hausgeräte GmbH, 81739 München (DE)
(72) Erfinder: Schmidt, Sebastian, 12159 Berlin (DE)

(57) **Zusammenfassung**

Die vorliegende Erfindung betrifft ein Wäschepflegegerät (100) mit einem Gerätegehäuse (101), welches einen Geräteinnenraum (103) des Wäschepflegegeräts (100) gegenüber einem Außenraum (105) des Wäschepflegegeräts (100) abgrenzt, wobei das Wäschepflegegerät (100) ein Blendenelement (107) aufweist, welches an einer Gehäusevorderseite (109) des Gerätegehäuses (101) angeordnet ist. Das Blendenelement (107) weist ein Beleuchtungselement (135) auf, welches eine Mehrzahl von einzeln ansteuerbaren organischen Leuchtdioden (OLED) aufweist, und wobei das Beleuchtungselement (135) ausgebildet ist, eine dem Gerätegehäuse (101) abgewandte Blendenaußenseite (115) des Blendenelements (107) zu beleuchten.

## Beschreibung

Die vorliegende Erfindung betrifft ein Wäschepflegegerät mit einem Beleuchtungselement.

In einem herkömmlichen Wäschepflegegerät interagieren Nutzer des Wäschepflegegeräts üblicherweise über Nutzerschnittstellen, wie beispielsweise Drehschaltern oder Drehknöpfen, mit dem Wäschepflegegerät. Entsprechende Nutzerschnittstellen sind üblicherweise an einem Blendenelement des Wäschepflegegeräts angeordnet, welches eine Gerätevorderseite des Gerätegehäuses des Wäschepflegegeräts abdeckt.

Um in einem schlecht beleuchteten Aufstellraum des herkömmlichen Wäschepflegegeräts eine wirksame Interaktion des Nutzers mit der Nutzerschnittstelle sicherzustellen, muss eine dem Außenraum des Wäschepflegegeräts zugewandte Blendenaußenseite des Blendenelements wirksam beleuchtet werden. Bei herkömmlichen Beleuchtungslösungen einer entsprechenden Blendenaußenseite ergibt sich jedoch oftmals der Nachteil einer inhomogenen Beleuchtung, bzw. einer räumlich ungleichmäßigen Abstrahlcharakteristik entsprechender Beleuchtungen.

Es ist die der Erfindung zugrundeliegende Aufgabe, ein Wäschepflegegerät mit einem Blendenelement anzugeben, bei dem eine vorteilhafte Beleuchtung des Blendenelements erreicht werden kann.

Diese Aufgabe wird durch den Gegenstand mit den Merkmalen nach dem unabhängigen Anspruch gelöst. Vorteilhafte Ausführungsformen sind Gegenstand der abhängigen Ansprüche, der Beschreibung und der Zeichnungen.

Gemäß einem Aspekt wird die erfindungsgemäße Aufgabe durch ein Wäschepflegegerät gelöst, mit einem Gerätegehäuse, welches einen Geräteinnenraum des Wäschepflegegeräts gegenüber einem Außenraum des Wäschepflegegeräts abgrenzt, wobei das Wäschepflegegerät ein Blendenelement aufweist, welches an einer Gehäusevorderseite des Gerätegehäuses angeordnet ist, wobei das Blendenelement ein Beleuchtungselement aufweist, welches eine Mehrzahl von einzeln ansteuerbaren organischen Leuchtdioden (OLED) aufweist, und wobei das Beleuchtungselement ausgebildet ist, eine dem Gerätegehäuse abgewandte Blendenaußenseite des Blendenelements zu beleuchten.

Dadurch wird der technische Vorteil erreicht, dass durch die Verwendung von flächigen Lichtquellen, wie organischen Leuchtdioden (OLED), im Gegensatz zu punktförmigen Lichtquellen, wie herkömmlichen LEDs, auf die Einhaltung eines Mindestabstands, sowie auf die Verwendung eines Diffusors verzichtet werden kann, und somit eine homogene Ausleuchtung der Blendenaußenseite alleine durch die Abstrahlcharakteristik der OLEDs gegeben ist und gleichzeitig Bauteile und Bauraum eingespart werden kann.

Durch die Verwendung von OLEDs kann das Beleuchtungselement sehr dünn gehalten werden, und kann dieses insbesondere als eine OLED-Folie ausgebildet sein. Somit erlaubt der sehr flache Aufbau einer entsprechenden OLED-Folie, insbesondere mit einer Dicke von weniger als 2 mm, die Integration des Beleuchtungselements in Bauräume, in denen ansonsten keine Beleuchtungselemente untergebracht werden könnten, so dass eine vorteilhafte Optimierung der Position des Beleuchtungselements vorgenommen werden kann.

Durch die Einsparung von Bauteilen und die Möglichkeit, die OLEDs in einem industriellen Druckprozess zu fertigen, ergeben sich sehr hohe Kosteneinsparungspotentiale im Vergleich zu herkömmlichen LED Modulen. Zudem benötigt das OLED umfassende Beleuchtungselement keine Leiterplatte als Träger für die OLEDs. Der Reduzierung an benötigter Leiterplattenfläche führt zu einer verbesserten Bewertung des CO₂-Äquivalents.

Insbesondere ist das Blendenelement an einem an die Gehäuseoberseite angrenzenden Bereich der Gehäusevorderseite des Gerätegehäuses angeordnet.

Insbesondere ist das Beleuchtungselement ausgebildet, die Blendenaußenseite vollflächig oder nur abschnittsweise zu beleuchten.

Insbesondere weist das Wäschepflegegerät eine Steuerung auf, welche steuerungstechnisch mit den einzeln ansteuerbaren organischen Leuchtdioden (OLED) des Beleuchtungselements verbunden ist, wobei die Steuerung ausgebildet ist, die einzeln ansteuerbaren organischen Leuchtdioden (OLED) des Beleuchtungselements einzeln zu aktivieren, um die Blendenaußenseite des Blendenelements bereichsweise zu beleuchten.

Insbesondere umfassen die organischen Leuchtdioden (OLED) des Beleuchtungselements jeweils flächige organische Leuchtdioden (OLED).

In einer vorteilhaften Ausführungsform ist das Beleuchtungselement als eine flexible Folie ausgebildet, wobei die flexible Folie die organischen Leuchtdioden (OLED) aufweist.

Dadurch wird der technische Vorteil erreicht, dass die OLEDs aufweisende Folie biegsam ist und sich an Oberflächen, die eine einfache Krümmung aufweisen, problemlos anpassen kann.

Insbesondere sind die organischen Leuchtdioden (OLEDs) durch die Folie umschlossen, insbesondere fluiddicht umschlossen. Dadurch, dass die OLEDs damit insbesondere innerhalb der Folie untergebracht sind, ist es nicht notwendig, dieses Bauteil nach außen abzudichten, um die unbeabsichtigte Leitung elektrischen Stroms durch Feuchtigkeit zu verhindern.

In einer vorteilhaften Ausführungsform weist das Beleuchtungselement eine Mehrzahl von räumlich voneinander getrennten Segmenten auf, wobei jeweils ein Segment der Mehrzahl von räumlich voneinander getrennten Segmenten jeweils eine organische Leuchtdiode (OLED) der Mehrzahl von einzeln ansteuerbaren organischen Leuchtdioden (OLED) aufweist.

Dadurch wird der technische Vorteil erreicht, dass durch die Segmentierung des Beleuchtungselements die Abstrahlfläche der jeweiligen organischen Leuchtdioden (OLED) beschränkt werden kann, so dass durch die Aktivierung einer einzigen einzeln ansteuerbaren organischen Leuchtdiode (OLED) in dem entsprechenden Segment eine flächig definierte Lichtabstrahlung erreicht wird.

In einer vorteilhaften Ausführungsform weist das Beleuchtungselement ein Substrat auf, und sind die organischen Leuchtdioden (OLED) als auf das Substrat aufgedruckte organische Leuchtdioden (OLED) ausgebildet.

Dadurch wird der technische Vorteil erreicht, dass durch die Möglichkeit, die OLEDs mittels eines Druckprozesses zu fertigen, sich ein stark erweiterter Gestaltungsspielraum für das Beleuchtungselement ergibt.

In einer vorteilhaften Ausführungsform weist das Beleuchtungselement eine Mehrzahl von Leiterbahnen zum elektrischen Verbinden der organischen Leuchtdioden (OLED) auf, und sind die Mehrzahl von Leiterbahnen insbesondere als auf das Substrat aufgedruckte Leiterbahnen ausgebildet.

Dadurch wird der technische Vorteil erreicht, dass durch die Leiterbahnen eine wirksame elektrische Anbindung der organischen Leuchtdioden (OLED) sichergestellt ist.

In einer vorteilhaften Ausführungsform weist das Wäschepflegegerät eine elektrische Energieversorgungseinheit auf, welche elektrisch, insbesondere drahtlos oder drahtgebunden mit dem Beleuchtungselement verbunden ist, um die organischen Leuchtdioden (OLED) des Beleuchtungselements mit elektrischer Energie zu versorgen.

Dadurch wird der technische Vorteil erreicht, dass ein wirksamer Betrieb der organischen Leuchtdioden (OLED) des Beleuchtungselements erreicht wird.

In einer vorteilhaften Ausführungsform ist das Beleuchtungselement einstückig mit dem Blendenelement gefertigt, insbesondere als ein gemeinsames Spritzgussteil, oder ist das Beleuchtungselement mit einer dem Gerätegehäuse zugewandten Blendeninnenseite des Blendenelements verbunden, insbesondere stoffschlüssig verbunden.

Dadurch wird der technische Vorteil erreicht, dass eine einstückige Fertigung des Beleuchtungselements zusammen mit dem Blendenelement eine besonders kostengünstige Herstellungsmöglichkeit umfasst. Durch eine mehrstückige Ausbildung von Beleuchtungselement und Blendenelement kann eine wirksam nachträglich optimierte Positionierung des Beleuchtungselements an dem Blendenelement sichergestellt werden.

In einer vorteilhaften Ausführungsform weist das Blendenelement ein zumindest teilweise transparentes Blendenelementgehäuse auf, und/oder weist das Blendenelement zumindest eine Beleuchtungsöffnung auf, wobei das Beleuchtungselement ausgebildet ist, die Blendenaußenseite durch das zumindest teilweise transparente Blendenelementgehäuse oder durch die zumindest eine Beleuchtungsöffnung zu beleuchten.

Dadurch wird der technische Vorteil erreicht, dass das durch das Beleuchtungselement abgestrahlte Licht entweder großflächig durch das zumindest teilweise transparente Blendenelementgehäuse zu der Blendenaußenseite vordringen kann, und/oder dass das durch das Beleuchtungselement abgestrahlte Licht räumlich begrenzt durch die Beleuchtungsöffnung zu der Blendenaußenseite vordringen kann.

In einer vorteilhaften Ausführungsform ist das Blendenelement ausgebildet, auf der Blendenaußenseite des Blendenelements alphanumerische Symbole und/oder graphische Elemente darzustellen, und/oder ist das Blendenelement ausgebildet, die Blendenaußenseite zumindest abschnittsweise flächig zu beleuchten.

Dadurch wird der technische Vorteil erreicht, dass eine flächige Beleuchtung der Blendenaußenseite eine großflächige Beleuchtung für den Nutzer sicherstellt.

Alternativ oder zusätzlich können durch das Blendenelement, alphanumerische Symbole, wie beispielweise Buchstaben, Ziffern und/oder Wörter, und/oder graphische Elemente, wie Bilder und/oder Bildsymbole, auf der Blendenaußenseite dargestellt werden. Die Symbole und/oder Elemente können beispielsweise durch die OLEDs des Beleuchtungselements direkt an die Blendenaußenseite projiziert werden, und/oder oder an dem Blendenelement kann hierbei eine entsprechende Projektionsfläche ausgebildet sein, um die entsprechenden Symbole und/oder Elemente darzustellen, und/oder es können an dem Blendenelement hierbei Aussparungen vorhanden sein, welche durch die OLEDs des Beleuchtungselements auf einer Blendeninnenseite hinterleuchtet werden, um die entsprechenden Symbole und/oder Elemente auf der Blendenaußenseite darzustellen.

In einer vorteilhaften Ausführungsform ist das Blendenelement einstückig ausgebildet, oder ist das Blendenelement mehrteilig ausgebildet, wobei hierbei das Blendenelement insbesondere zumindest eine Blendenaussparung aufweist, welche in der Blendenaußenseite des Blendenelements geformt ist, und wobei hierbei dass Blendenelement insbesondere ein Einlegeelement aufweist, welches die Blendenaussparung abdeckt, wobei hierbei insbesondere das Einlegeelement das Beleuchtungselement aufweist, und wobei hierbei das Beleuchtungselement insbesondere ausgebildet ist, eine dem Gerätegehäuse abgewandte Einlegeelementaußenseite des Einlegeelements zu beleuchten.

Dadurch wird der technische Vorteil erreicht, dass die Verwendung eines in der Blendenaussparung angeordneten Einlegeelements eine Vereinfachung der Montage der Beleuchtungselements bewirkt.

In einer vorteilhaften Ausführungsform weist das Wäschepflegegerät zumindest eine Nutzerschnittstelle, insbesondere Drehknopf und/oder Druckknopf, zum Auswählen von Wäschepflegeparametern des Wäschepflegegeräts auf, und ist die Nutzerschnittstelle an der Blendenaußenseite des Blendenelements angeordnet, und wobei das Beleuchtungselement insbesondere ausgebildet ist, die Nutzerschnittstelle zu beleuchten.

Dadurch wird der technische Vorteil erreicht, dass eine entsprechend beleuchtete Nutzerschnittstelle eine wirksame Interaktion des Nutzers mit der Nutzerschnittstelle auch in einem nicht vorteilhaft beleuchteten Aufstellraum des Wäschepflegegeräts sicherstellt.

In einer vorteilhaften Ausführungsform weist die Nutzerschnittstelle ein durch den Nutzer betätigbares Betätigungselement auf, welches an der Blendenaußenseite, insbesondere an der Einlegeelementaußenseite angeordnet ist, und weist die Nutzerschnittstelle ein Kontaktelement zum Kontaktieren einer elektrischen Steuerung des Wäschepflegegeräts auf, wobei das Kontaktelement mit dem Betätigungselement verbunden ist und sich von der Blendenaußenseite, insbesondere der Einlegeelementaußenseite, zu einer Blendeninnenseite, insbesondere Einlegeelementinnenseite, erstreckt, wobei das Beleuchtungselement, insbesondere das Einlegeelement, eine Beleuchtungselementöffnung aufweist, durch welche das Kontaktelement geführt ist.

Dadurch wird der technische Vorteil erreicht, dass eine wirksame steuerungstechnische Anbindung der an der Blendenaußenseite angeordneten Nutzerschnittstelle erreicht wird.

In einer vorteilhaften Ausführungsform ist an der Blendenaußenseite, insbesondere Einlegeelementaußenseite, eine berührungssensitive weitere Nutzerschnittstelle, insbesondere eine Touchfolie, angeordnet, zur Interaktion des Nutzers mit dem Wäschepflegegerät.

Insbesondere ist das Beleuchtungselement ausgebildet, die weitere Nutzerschnittstelle zu beleuchten.

Dadurch wird der technische Vorteil erreicht, dass eine entsprechende berührungssensitive weitere Nutzerschnittstelle zusätzlich zu einer optionalen Nutzerschnittstelle, wie beispielsweise einem Drehknopf und/oder einem Drehschalter, eine wirksame Interaktion mit dem Wäschepflegegerät ermöglicht.

In einer vorteilhaften Ausführungsform weist das Blendenelement eine Schalenöffnung auf, in welcher eine Einspülschale des Wäschepflegegeräts aufgenommen ist, wobei das Beleuchtungselement insbesondere neben der Schalenöffnung an der Blendenaußenseite, insbesondere Einlegeelementaußenseite, angeordnet ist.

Dadurch wird der technische Vorteil erreicht, dass durch die Einspülschale wirksam Wäschepflegesubstanz dem Wäschepflegegerät zur Verfügung gestellt werden kann.

In einer vorteilhaften Ausführungsform weist das Beleuchtungselement keinen Diffusor auf.

Dadurch wird der technische Vorteil erreicht, dass auf das entsprechende Bauelement verzichtet werden kann, wodurch sich eine Vereinfachung und Kostenersparnis ergibt.

Ausführungsbeispiele der Erfindung sind in den Zeichnungen dargestellt und werden im Folgenden näher beschrieben.

Es zeigen:
- Fig. 1: eine schematische Ansicht eines Wäschepflegegeräts mit einem Blendenelement gemäß einer Ausführungsform;
- Fig. 2: eine perspektivische Ansicht eines Wäschepflegegeräts mit einem Blendenelement und mit einem Beleuchtungselement gemäß einer Ausführungsform; und
- Fig. 3: eine Darstellung eines Beleuchtungselements eines Wäschepflegegeräts gemäß der Fig. 2.

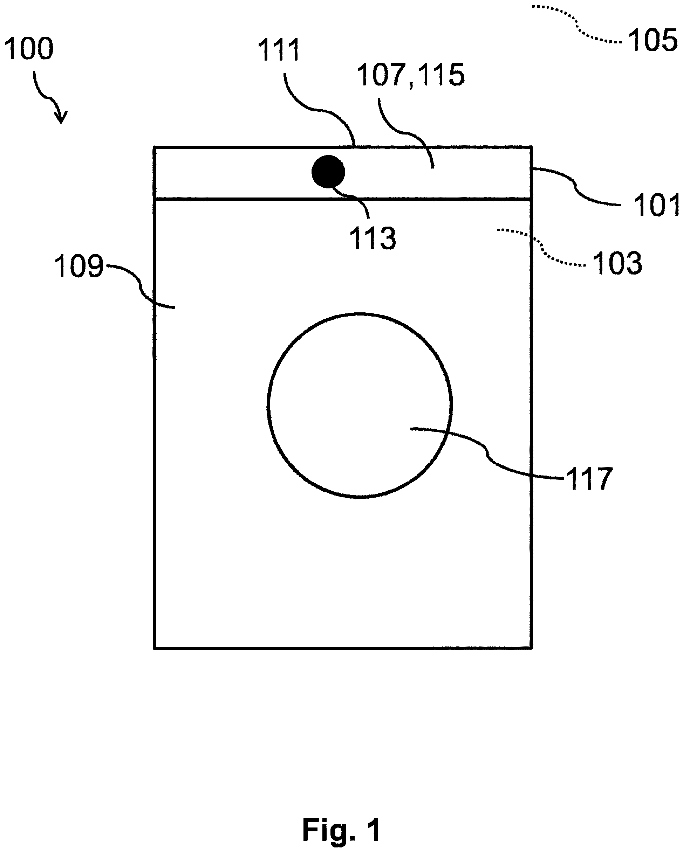

Fig. 1 zeigt eine schematische Ansicht eines Wäschepflegegeräts mit einem Blendenelement gemäß einer Ausführungsform, insbesondere eines allgemeinen Wäschepflegegeräts 100, wie z.B. eine Waschmaschine. Das Wäschepflegegerät 100 weist ein Gerätegehäuse 101 auf, welches einen in Fig. 1 lediglich schematisch dargestellten Geräteinnenraum 103 des Wäschepflegegeräts 100 gegenüber einem in Fig. 1 lediglich schematisch dargestellten Außenraum 105 des Wäschepflegeräts 100 abgrenzt.

Das Wäschepflegegerät 100 weist ein Blendenelement 107 auf, welches an einer Gehäusevorderseite 109 des Gerätegehäuses 101 angeordnet ist. Wie aus der Fig. 1 zu entnehmen ist, ist das Blendenelement 107 an einem an die Gehäuseoberseite 111 angrenzenden Bereich der Gehäusevorderseite 109 des Gerätegehäuses 101 angeordnet.

Wie aus der Fig. 1 ferner hervorgeht, weist das Wäschepflegegerät 100 optional zumindest eine Nutzerschnittstelle 113, wie beispielsweise einen Drehknopf oder Druckknopf, zum Auswählen von Wäschepflegeparametern des Wäschepflegegeräts 100 auf. Hierbei ist die Nutzerschnittstelle 113 an einer dem Außenraum 105 des Wäschepflegegeräts 100 zugewandten Blendenaußenseite 115 des Blendenelements 107 angeordnet.

Zudem ist an der Gehäusevorderseite 109 eine in der Fig. 1 lediglich schematisch dargestellte Gerätetür 117 angeordnet.

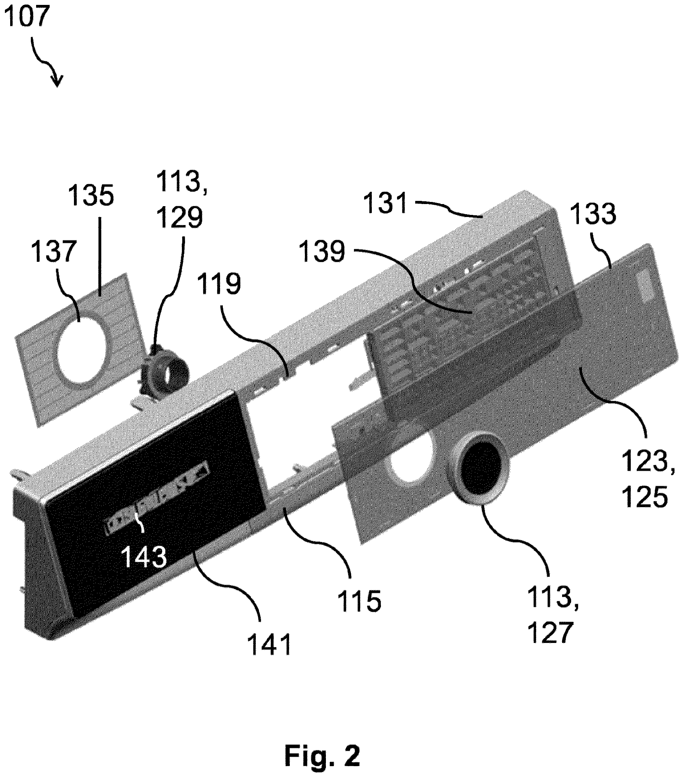

Fig. 2 zeigt eine perspektivische Ansicht eines Wäschepflegegeräts mit einem Blendenelement und mit einem Beleuchtungselement gemäß einer Ausführungsform.

In der Fig. 2 ist eine Explosivdarstellung eines Blendenelements 107 eines Wäschepflegegeräts 100 gezeigt, wobei das Blendenelement 107 analog zur Fig. 1 an einer Gehäusevorderseite 109 des Gerätegehäuses 101 angeordnet ist. Das Gerätegehäuse 101 ist in der Fig. 2 nicht dargestellt.

Wie aus der Fig. 2 hervorgeht, ist das Blendenelement 107 insbesondere mehrteilig ausgebildet. Das Blendenelement 107 weist hierbei insbesondere eine Blendenaussparung 119 auf, welche in der Blendenaußenseite 115 des Blendenelements 107 geformt ist. Das Blendenelement 107 weist ein zumindest teilweise transparentes Einlegeelement 123 auf, welches die Blendenaussparung 119 abdeckt. Eine Nutzerschnittstelle 113 ist hierbei an einer einem Außenraum 105 des Wäschepflegegeräts 100 zugewandten Einlegeelementaußenseite 125 des Einlegeelements 123 angeordnet.

Wie aus der Fig. 2 hervorgeht umfasst die Nutzerschnittstelle 113 hierbei insbesondere einen Drehknopf.

Die Nutzerschnittstelle 113 weist hierbei ein durch den Nutzer betätigbares Betätigungselement 127 auf, welches an der Blendenaußenseite 115, insbesondere an der Einlegeelementaußenseite 125 angeordnet ist. Der Nutzer kann durch das Betätigungselement 127 die Nutzerschnittstelle 113 das Wäschepflegegerät bedienen.

Wie aus der Fig. 2 ferner zu entnehmen ist, weist die Nutzerschnittstelle 113 ein Kontaktelement 129 zum Kontaktieren einer in Fig. 2 nicht dargestellten elektrischen Steuerung des Wäschepflegegeräts 100 auf. Das Kontaktelement 129 ist mit dem Betätigungselement 127 verbunden und erstreckt sich von der Blendenaußenseite 115, insbesondere der Einlegeelementaußenseite 125, zu einer Blendeninnenseite 131, insbesondere Einlegeelementinnenseite 133.

Das Wäschepflegegerät 100 weist ein Beleuchtungselement 135 auf, welches in Fig. 2 nicht dargestellte organische Leuchtdioden (OLED) umfasst. Das Beleuchtungselement 135 ist an der dem Außenraum 105 des Wäschepflegegeräts 100 abgewandten Blendeninnenseite 131, insbesondere Einlegeelementinnenseite 133 angeordnet, wobei hierbei eine stoffschlüssige Verbindung, insbesondere eine Verklebung, bevorzugt ist.

Das Beleuchtungselement 135 ist ausgebildet, die Blendenaußenseite 115, insbesondere die Einlegeelementaußenseite 125, zu beleuchten. Insbesondere ist das Beleuchtungselement 135 alternativ oder zusätzlich ausgebildet, die Nutzerschnittstelle 113 zu beleuchten. Insbesondere ist das Beleuchtungselement 135 alternativ oder zusätzlich ausgebildet auf der Blendenaußenseite 115 alphanumerische Symbole und/oder graphische Elemente darzustellen. Insbesondere ist das Beleuchtungselement 135 alternativ oder zusätzlich ausgebildet die Blendenaußenseite 115 zumindest abschnittsweise flächig zu beleuchten.

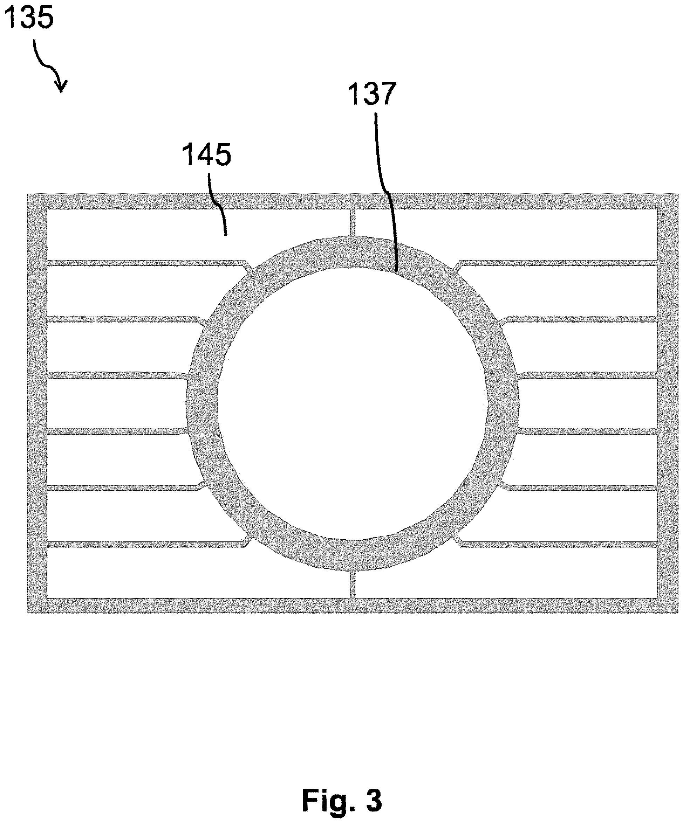

Für weitere Details zur Ausgestaltung des Beleuchtungselements 135 wird auf die Ausführungen zur Fig. 3 verwiesen.

Das in der Fig. 2 dargestellte Beleuchtungselement 135 ist insbesondere als eine flexible Folie ausgebildet, auf welcher die in Fig. 2 nicht dargestellten organischen Leuchtdioden angeordnet sind. Durch die Flexibilität des als flexible Folie ausgebildeten Beleuchtungselements 135 kann eine besonders vorteilhafte Befestigung des Beleuchtungselements 135 an der Blendeninnenseite 131, insbesondere Einlegeelementinnenseite 133, erreicht werden.

Das Beleuchtungselement 135 weist ferner insbesondere eine Beleuchtungselementöffnung 137 auf, durch welche das Kontaktelement 129 der Nutzerschnittstelle 113 geführt ist.

Das Beleuchtungselement 135 ist hierbei an einer der Einlegeelementaußenseite 125 des Einlegeelements 123 abgewandten Einlegeelementinnenseite 133 angeordnet und ist ausgebildet, die Einlegeelementaußenseite 125 des zumindest teilweise transparenten Einlegeelements 123 zu beleuchten.

Alternativ oder zusätzlich kann das Blendenelement 107, insbesondere das Einlegeelement 123, zumindest eine in Fig. 2 nicht dargestellte Beleuchtungsöffnung aufweisen, wobei das an der Blendeninnenseite 131 angeordnete Beleuchtungselement 135 ausgebildet ist, die Blendenaußenseite 115 durch das zumindest teilweise transparentes Blendenelement 107 und/oder durch die zumindest eine Beleuchtungsöffnung zu beleuchten.

Insbesondere ist an der Blendenaußenseite 115 eine berührungssensitive weitere Nutzerschnittstelle 139, insbesondere eine Touchfolie, angeordnet, zur Interaktion des Nutzers mit dem Wäschepflegegerät 100.

Zudem ist in der Fig. 2 noch eine Schalenöffnung 141 des Blendenelements 107 gezeigt, in welcher eine Einspülschale 143 des Wäschepflegegeräts 100 zur Aufnahme von Wäschepflegesubstanz aufgenommen ist, wobei die Nutzerschnittstelle 113 neben der Schalenöffnung 141 an der Blendenaußenseite 115 angeordnet ist.

Die homogene Hinterleuchtung einer Lichtaustrittsfläche ist bei punktförmigen Lichtquellen wie LEDs nur durch Einhaltung eines Mindestabstands sowie der Nutzung eines Diffusors möglich. Bei der Verwendung des erfindungsgemäßen Beleuchtungselements 135 mit flächig Licht abstrahlenden OLEDs fallen sowohl Abstand als auch der Diffusor weg, wodurch Bauteile und Bauraum eingespart werden. Die homogene Ausleuchtung ist allein durch die Abstrahlcharakteristik der OLEDs gegeben.

Der sehr flache Aufbau einer entsprechenden OLED-Folie, insbesondere mit einer Dicke von weniger als 2 mm, erlaubt die Integration des Beleuchtungselements 135 in Bauräume, in denen ansonsten keine Beleuchtungselemente 135 untergebracht werden könnten.

Die OLED Folie ist zudem biegsam und kann sich an Oberflächen, die eine einfache Krümmung aufweisen, problemlos anpassen. Eine konventionelle LED-Lösung ist durch die stets flache Leiterplatte unflexibler.

Durch die Möglichkeit, die OLEDs mittels eines Druckprozesses zu fertigen, ergibt sich ein stark erweiterter Gestaltungsspielraum für dieses Beleuchtungselement 135. Es ist darüber hinaus möglich, die Folien im Spritzguss zu integrieren.

Dadurch, dass die OLEDs in einer Folie untergebracht sind, ist es nicht notwendig, dieses Bauteil nach außen abzudichten, um die unbeabsichtigte Leitung elektrischen Stroms durch Feuchtigkeit zu verhindern.

Durch die Einsparung von Bauteilen und die Möglichkeit, die OLEDs in einem industriellen Druckprozess zu fertigen, ergeben sich sehr hohe Kosteneinsparungspotentiale im Vergleich zu herkömmlichen LED Modulen.

Einen der höchsten Einflüsse auf das CO₂-Äquivalent haben Leiterplatten. Die OLED Folie benötigt keine Leiterplatte als Träger für Lichtquellen. Der Reduzierung an benötigter Leiterplattenfläche führt zu einer verbesserten Bewertung des CO₂-Äquivalents.

Fig. 3 zeigt eine Darstellung eines Beleuchtungselements eines Wäschepflegegeräts gemäß der Fig. 2.

Das in der Fig. 2 dargestellte Beleuchtungselement 135 ist in der Fig. 3 vergrößert dargestellt. Das Beleuchtungselement 135 weist eine Mehrzahl von einzeln ansteuerbaren organischen Leuchtdioden (OLED) auf.

Insbesondere weist das Beleuchtungselement 135 eine Mehrzahl von räumlich voneinander getrennten Segmenten 145 auf, wobei jeweils ein Segment 145 der Mehrzahl von räumlich voneinander getrennten Segmenten 145 jeweils eine organische Leuchtdiode (OLED) der Mehrzahl von einzeln ansteuerbaren organischen Leuchtdioden (OLED) aufweist. Somit kann eine wirksame lokal begrenzte Lichtemission durch das jeweilige Segment 145, bzw. durch die jeweiligen Segmente 145 sichergestellt werden.

Hierbei weist das Beleuchtungselement 135 insbesondere ein Substrat auf, wobei die organischen Leuchtdioden (OLED) insbesondere als auf das Substrat aufgedruckte organische Leuchtdioden (OLED) ausgebildet sind.

Um die organischen Leuchtdioden (OLED) des Beleuchtungselements 135 mit elektrischer Energie zu versorgen, weist das Wäschepflegegerät 100 eine elektrische Energieversorgungseinheit auf, welche elektrisch, insbesondere drahtlos oder drahtgebunden mit dem Beleuchtungselement 135 verbunden ist.

Hierbei weist das Beleuchtungselement 135 insbesondere eine Mehrzahl von in Fig. 2 nicht dargestellten Leiterbahnen zum elektrischen Verbinden der organischen Leuchtdioden (OLED) auf, wobei hierbei die Mehrzahl von Leiterbahnen insbesondere als auf das Substrat aufgedruckte Leiterbahnen ausgebildet sind.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### Bezugszeichenliste

- 100: Wäschepflegegerät
- 101: Gerätegehäuse
- 103: Geräteinnenraum
- 105: Außenraum des Wäschepflegeräts
- 107: Blendenelement
- 109: Gehäusevorderseite
- 111: Gehäuseoberseite
- 113: Nutzerschnittstelle
- 115: Blendenaußenseite
- 117: Gerätetür
- 119: Blendenaussparung
- 123: Einlegeelement
- 125: Einlegeelementaußenseite
- 127: Betätigungselement
- 129: Kontaktelement
- 131: Blendeninnenseite
- 133: Einlegeelementinnenseite
- 135: Beleuchtungselement
- 137: Beleuchtungselementöffnung
- 141: Schalenöffnung
- 143: Einspülschale
- 145: Segment

## Patentansprüche

1. Wäschepflegegerät (100) mit einem Gerätegehäuse (101), welches einen Geräteinnenraum (103) des Wäschepflegegeräts (100) gegenüber einem Außenraum (105) des Wäschepflegegeräts (100) abgrenzt, wobei das Wäschepflegegerät (100) ein Blendenelement (107) aufweist, welches an einer Gehäusevorderseite (109) des Gerätegehäuses (101) angeordnet ist, **dadurch gekennzeichnet, dass**
wobei das Blendenelement (107) ein Beleuchtungselement (135) aufweist, welches eine Mehrzahl von einzeln ansteuerbaren organischen Leuchtdioden (OLED) aufweist, und wobei das Beleuchtungselement (135) ausgebildet ist, eine dem Gerätegehäuse (101) abgewandte Blendenaußenseite (115) des Blendenelements (107) zu beleuchten.

2. Wäschepflegegerät (100) nach Anspruch 1, **dadurch gekennzeichnet, dass** das Beleuchtungselement (135) als eine flexible Folie ausgebildet ist, wobei die flexible Folie die organischen Leuchtdioden (OLED) aufweist.

3. Wäschepflegegerät (100) nach Anspruch 1 oder 2, **dadurch gekennzeichnet, dass** das Beleuchtungselement (135) eine Mehrzahl von räumlich voneinander getrennten Segmenten (145) aufweist, wobei jeweils ein Segment (145) der Mehrzahl von räumlich voneinander getrennten Segmenten (145) jeweils eine organische Leuchtdiode (OLED) der Mehrzahl von einzeln ansteuerbaren organischen Leuchtdioden (OLED) aufweist.

4. Wäschepflegegerät (100) nach einem der vorangehenden Ansprüche, **dadurch gekennzeichnet, dass** das Beleuchtungselement (135) ein Substrat aufweist, und dass die organischen Leuchtdioden (OLED) als auf das Substrat aufgedruckte organische Leuchtdioden (OLED) ausgebildet sind.

5. Wäschepflegegerät (100) nach einem der vorangehenden Ansprüche, **dadurch gekennzeichnet, dass** das Beleuchtungselement (135) eine Mehrzahl von Leiterbahnen zum elektrischen Verbinden der organischen Leuchtdioden (OLED) aufweist, und dass die Mehrzahl von Leiterbahnen insbesondere als auf das Substrat aufgedruckte Leiterbahnen ausgebildet sind.

6. Wäschepflegegerät (100) nach einem der vorangehenden Ansprüche, **dadurch gekennzeichnet, dass** das Wäschepflegegerät (100) eine elektrische Energieversorgungseinheit aufweist, welche elektrisch, insbesondere drahtlos oder drahtgebunden mit dem Beleuchtungselement (135) verbunden ist, um die organischen Leuchtdioden (OLED) des Beleuchtungselements (135) mit elektrischer Energie zu versorgen.

7. Wäschepflegegerät (100) nach einem der vorangehenden Ansprüche, **dadurch gekennzeichnet, dass** das Beleuchtungselement (135) einstückig mit dem Blendenelement (107) gefertigt ist, insbesondere als ein gemeinsames Spritzguss teil, oder dass das Beleuchtungselement (135) mit einer dem Gerätegehäuse (101) zugewandten Blendeninnenseite (131) des Blendenelements (107) verbunden ist, insbesondere stoffschlüssig verbunden ist.

8. Wäschepflegegerät (100) nach einem der vorangehenden Ansprüche, **dadurch gekennzeichnet, dass** das Blendenelement (107) ein zumindest teilweise transparentes Blendenelementgehäuse aufweist, und/oder dass das Blendenelement (107) zumindest eine Beleuchtungsöffnung aufweist, wobei das Beleuchtungselement (135) ausgebildet ist, die Blendenaußenseite (115) durch das zumindest teilweise transparente Blendenelementgehäuse oder durch die zumindest eine Beleuchtungsöffnung zu beleuchten.

9. Wäschepflegegerät (100) nach einem der vorangehenden Ansprüche, **dadurch gekennzeichnet, dass** das Blendenelement (107) ausgebildet ist, auf der Blendenaußenseite (115) des Blendenelements (107) alphanumerische Symbole und/oder graphische Elemente darzustellen, und/oder dass das Blendenelement (107) ausgebildet ist, die Blendenaußenseite (115) zumindest abschnittsweise flächig zu beleuchten.

10. Wäschepflegegerät (100) nach einem der vorangehenden Ansprüche, **dadurch gekennzeichnet, dass** das Blendenelement (107) einstückig ausgebildet ist, oder dass das Blendenelement (107) mehrteilig ausgebildet ist, wobei hierbei das Blendenelement (107) insbesondere zumindest eine Blendenaussparung (119) aufweist, welche in der Blendenaußenseite (115) des Blendenelements (107) geformt ist, und wobei hierbei dass Blendenelement (107) insbesondere ein Einlegeelement (123) aufweist, welches die Blendenaussparung (119) abdeckt, wobei hierbei insbesondere das Einlegeelement (123) das Beleuchtungselement (135) aufweist, und wobei hierbei das Beleuchtungselement (135) insbesondere ausgebildet ist, eine dem Gerätegehäuse (101) abgewandte Einlegeelementaußenseite (125) des Einlegeelements (123) zu beleuchten.

11. Wäschepflegegerät (100) nach einem der vorangehenden Ansprüche, **dadurch gekennzeichnet, dass** das Wäschepflegegerät (100) zumindest eine Nutzerschnittstelle (113), insbesondere Drehknopf und/oder Druckknopf, zum Auswählen von Wäschepflegeparametern des Wäschepflegegeräts (100) aufweist, und wobei die Nutzerschnittstelle (113) an der Blendenaußenseite (115) des Blendenelements (107) angeordnet ist, und wobei das Beleuchtungselement (135) insbesondere ausgebildet ist, die Nutzerschnittstelle (113) zu beleuchten.

12. Wäschepflegegerät (100) nach Anspruch 11, **dadurch gekennzeichnet, dass** die Nutzerschnittstelle (113) ein durch den Nutzer betätigbares Betätigungselement (127) aufweist, welches an der Blendenaußenseite (115), insbesondere an der Einlegeelementaußenseite (125) angeordnet ist, und dass die Nutzerschnittstelle (113) ein Kontaktelement (129) zum Kontaktieren einer elektrischen Steuerung des Wäschepflegegeräts (100) aufweist, wobei das Kontaktelement (129) mit dem Betätigungselement (127) verbunden ist und sich von der Blendenaußenseite (115), insbesondere der Einlegeelementaußenseite (125), zu einer Blendeninnenseite (131), insbesondere Einlegeelementinnenseite (133), erstreckt, wobei das Beleuchtungselement (135), insbesondere das Einlegeelement (123), eine Beleuchtungselementöffnung (137) aufweist, durch welche das Kontaktelement (129) geführt ist.

13. Wäschepflegegerät (100) nach einem der vorangehenden Ansprüche, **dadurch gekennzeichnet, dass** an der Blendenaußenseite (115), insbesondere Einlegeelementaußenseite (125), eine berührungssensitive weitere Nutzerschnittstelle (139), insbesondere eine Touchfolie, angeordnet ist, zur Interaktion des Nutzers mit dem Wäschepflegegerät (100).

14. Wäschepflegegerät (100) nach einem der vorangehenden Ansprüche, **dadurch gekennzeichnet, dass** das Blendenelement (107) eine Schalenöffnung (141) aufweist, in welcher eine Einspülschale (143) des Wäschepflegegeräts (100) aufgenommen ist, wobei das Beleuchtungselement (135) insbesondere neben der Schalenöffnung (141) an der Blendenaußenseite (115), insbesondere Einlegeelementaußenseite (125), angeordnet ist.

15. Wäschepflegegerät (100) nach einem der vorangehenden Ansprüche, **dadurch gekennzeichnet, dass** das Beleuchtungselement (135) keinen Diffusor aufweist.
